Europäisches Patentamt

European Patent Office

Office européen des brevets

(11) Publication number: **0 614 124 A2**

# EUROPEAN PATENT APPLICATION

(21) Application number: **94101387.2**

(22) Date of filing: **31.01.94**

(51) Int. Cl.5: **G03F 7/20**

(30) Priority: **01.02.93 JP 14482/93**
**01.02.93 JP 14483/93**

(43) Date of publication of application:
**07.09.94 Bulletin 94/36**

(84) Designated Contracting States:
**DE FR NL**

(71) Applicant: **NIKON CORPORATION**
**2-3, Marunouchi 3-chome**
**Chiyoda-ku**
**Tokyo (JP)**

(72) Inventor: **Suzuki, Kazuaki**
**492-405, Imai Minami-cho,**
**Nakahara-ku**
**Kawasaki-shi, Kanagawa (JP)**

(74) Representative: **Patentanwälte Grünecker,**
**Kinkeldey, Stockmair & Partner**
**Maximilianstrasse 58**
**D-80538 München (DE)**

(54) **Exposure apparatus.**

(57) An apparatus for exposing a pattern formed on a mask (R) to a photosensitive substrate (W) comprises an illumination optical system (1-7) for illuminating said mask, said illumination optical system including a diaphragm member (6) arranged in a plane conjugate with the pattern of said mask or in the vicinity thereof for restricting an illumination area on said mask to a local area, a unit for synchronously scanning said mask and said photosensitive substrate relative to said illumination area along a predetermined direction to expose the pattern of said mask to said photosensitive substrate, and a light shielding member (8A,8B) arranged in the vicinity of said mask for shielding a light directed to said photosensitive substrate through the outside of the pattern area on said mask during the scan of said mask and said photosensitive substrate.

FIG. 1

## BACKGROUND OF THE INVENTION

### Field of the Invention

The present invention relates to an exposure method and an exposure apparatus for implementing the same which are suitably applied to a scanning exposure apparatus for exposing a pattern on a mask onto a photosensitive substrate by synchronously scanning the mask and the photosensitive substrate to an illumination area of rectangular or arcuate shape.

### Related Background Art

When a semiconductor device, a liquid crystal display device or a thin film magnetic head is to be manufactured by using a photo-lithography technology, a projection exposure apparatus which exposes a pattern of a photo-mask or a reticle (hereinafter collectively referred to as a reticle) onto a photosensitive substrate such as a wafer or a glass plate on which photo-resist is applied through a projection optical system has been used. Recently, as the size of a single chip pattern of the semiconductor device tends to increase, it is required to increase the exposure area on the photosensitive substrate so that a larger pattern of the reticle may be exposed.

In order to comply with the requirement of the increased area, a scanning projection exposure apparatus for exposing a pattern on a reticle onto a photosensitive substrate by synchronously scanning the reticle and the photosensitive substrate to an illumination area of rectangular, arcuate or hexagonal shape (hereinafter collectively referred to as a slit illumination area) has been developed (USP 4,747,678, USP 4,924,257). In the past, as shown in USP 5,194,893, in order to define a slit illumination area on the reticle, a movable light shielding means (view field diaphragm) for determining the slit illumination area is arranged at a position which is conjugate with the reticle or in the vicinity of the reticle. The shape of the slit illumination area on the reticle and the shape of the slit illumination area on the photosensitive substrate are controlled by a design constant or an apparatus constant.

In such a prior art apparatus, the following two major problems were encountered.

In general, an illumination optical system of the projection exposure apparatus is designed to illuminate the reticle with a uniform illumination light (exposure light). Accordingly, in the scanning projection exposure apparatus, in order to assure that the uniformity in the illumination is attained on the photosensitive substrate at the time when the exposure is completed after the scanning of the reticle and the photosensitive substrate relative to the slit illumination area, the width of the slit illumination area along the scan direction must be uniform.

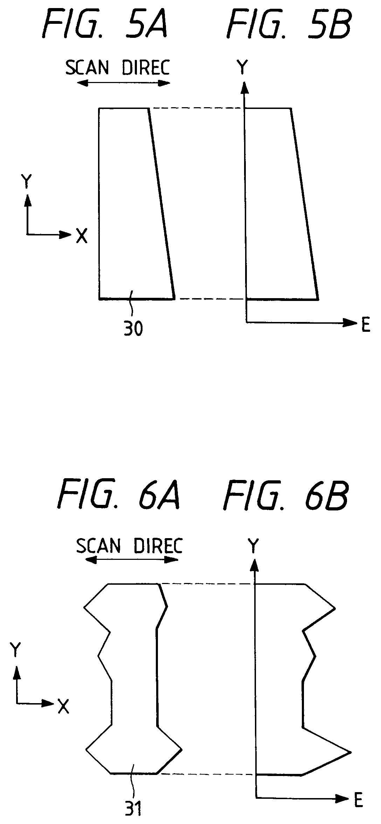

Assuming that X represents the scan direction to the slit illumination area and Y represents a non-scan direction perpendicular to the scan direction, if the width of the slit illumination area along the scan direction is not uniform, the parallelism of the slit illumination area 30 along the scan direction is bad as shown in Fig. 5A, or edges of the slit illumination area 31 along the scan direction include unevenness as shown in Fig. 6A. In the case of Fig. 5A, a distribution of the exposure intensity E along the non-scan direction (Y axis) measured on the photosensitive substrate gradually increases or decreases along the Y axis as shown in Fig. 5B. On the other hand, in the case of Fig. 6A, a distribution of the exposure intensity E along the non-scan direction (Y axis) measured on the photosensitive substrate varies irregularly along the Y axis as shown in Fig. 6B.

In the present projection exposure apparatus, a design rule of less than 0.5 $\mu$m which is in a sub-micron area is used. It is reported that the uniformity of the exposure intensity required for the control of a line width in such an area is as small as ±1%. Accordingly, in order to attain a sufficient uniformity of the illumination in the scanning projection exposure apparatus, the reduced unevenness of the edge along the scan direction is required for a view field diaphragm (stop) for determining the slit illumination area, and the control of the motion in changing the width of the view field diaphragm along the scan direction while maintaining sufficient parallelism of the edge along the scan direction is required, as disclosed in Japanese Laid-Open Patent Application No. 4-196513. As a result, it is difficult to control the operation of the illumination area setting means while keeping the required precision if the view field diaphragm for defining the slit illumination area is varied in synchronism with the scan by a reason to be described later.

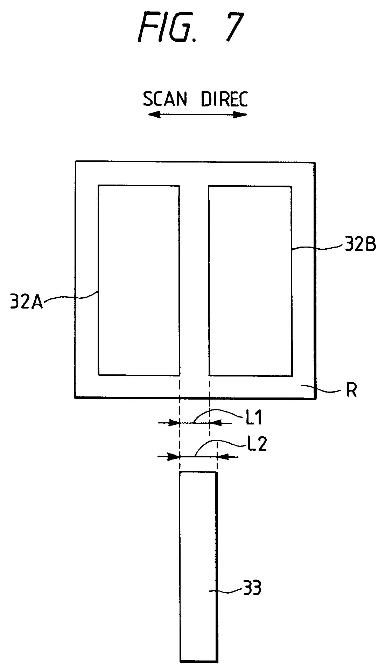

Further, as shown in Fig. 7, it is assumed that two circuit pattern areas 32A and 32B are arranged with a light shielding area of a width Ll therebetween on a reticle R, and the reticle R is scanned to a slit illumination area 33 of a width L2 along the scan direction. It is further assumed that the width L2 of the slit illumination area 33 is larger than the width Ll of the light shielding area between the circuit pattern areas 32A and 32B. In this case, if only the first circuit pattern area 32A of the reticle R is to be exposed onto the photosensitive substrate by the scanning exposure system, a portion of the pattern of the second circuit pattern area 32B is also transferred onto the photosensitive substrate.

In order to avoid the above problem, the width Ll of the light shielding area on the reticle R may be set to be sufficiently large but this would result in the reduction of the area of the circuit pattern area to be transferred. Alternatively, the width L2 of the slit illumination area 33 may be reduced in synchronism with the scan closely to the end of the exposure of the circuit pattern area 32A as shown in Japanese Laid-Open Patent Application No. 4-196513, but this would complicate the control mechanism for the variable view field diaphragm.

In the prior art projection exposure apparatus, the illumination optical system is designed to illuminate the reticle with a uniform illumination. Assuming that I (mW/cm$^2$) represents an illumination on a surface of the photo-sensitive substrate (image plane illumination), S (mJ/cm$^2$) represents a desired exposure intensity (sensitivity of a photosensitive material on the photosensitive substrate), D (mm) is a width of slit illumination area on the surface of the photosensitive substrate along the scan direction, and v (mm/sec) is a scan velocity of the photosensitive substrate, a required exposure time t (sec) is given by:

$$t = S/I = D/v \qquad (I)$$

The exposure intensity S is entered by an operator and the illumination I is normally determined by the intensity of the available light source. Accordingly, in order to attain the exposure intensity S entered by the operator, it is necessary to determine the scan velocity v in accordance with the width D of the slit illumination area along the scan direction. If the exposure intensity S is so small that the scan velocity v exceeds a maximum scan velocity $v_{max}$ permitted to the apparatus, it is necessary to reduce the illumination I by dimmer means in the illumination optical system or reduce the width D of the slit illumination area along the scan direction. Assuming that M represents a projection magnification of the projection optical system, the scan velocity of the reticle is given by V/M (mm/sec).

Figs. IIA to IID show various examples of the areas corresponding to the slit illumination area on the photosensitive substrate. Fig. IIA shows an area 130 corresponding to a rectangular illumination area of a width D along the scan direction. Fig. IIB shows an area 131 corresponding to an arcuate illumination area of a width D along the scan direction. Fig. IIC shows an area 132 corresponding to a hexagonal illumination area of a width D along the scan direction as disclosed in Japanese Laid-Open Patent Application No. 46-34057, in which opposite ends 132a and 132b of the area 132 perpendicular to the scan direction (along the non-scan direction) overlap with the adjacent scan areas to assume advantageous shapes when they are scanned. Fig. IID shows an area 133 corresponding to a diamond shaped illumination area of a width D along the scan direction as disclosed in Japanese Laid-Open Patent Application No. 53-25790, in which opposite ends 133a and 133b of the area 133 along the non-scan direction overlap with the adjacent scan areas to assume advantageous shapes when they are scanned.

However, since the prior art projection exposure apparatus is nor equipped with measurement means for the width D of the slit illumination area along the scan direction, it is difficult to expose to the photosensitive substrate with a proper exposure intensity if the actual width D along the scan direction deviates from a design value or the apparatus constant.

## SUMMARY OF THE INVENTION

It is an object of the present invention to provide a scanning exposure apparatus for exposing a pattern on a reticle onto a photosensitive substrate by synchronously scanning the reticle and the photosensitive substrate to a slit illumination area, wherein light shielding means (view field diaphragm) for defining the slit illumination area may be arranged in spaced relation with the reticle and only a pattern of a desired pattern area of a plurality of pattern areas on the reticle may be transferred onto the photosensitive substrate without changing the width of the slit illumination area during the exposure.

It is another object of the present invention to provide an exposure method to allow the exposure with a proper exposure intensity onto the photosensitive substrate when the pattern on the reticle is to be exposed onto the photosensitive substrate by synchronously scanning the reticle and the photosensitive substrate relative to the slit illumination area, and an exposure apparatus for implementing such exposure method.

The exposure apparatus of the present invention comprises an illumination optical system for illuminating a slit illumination area an a mask on which a pattern to be transferred is formed, and relative scan means for synchronously scanning the mask and a photosensitive substrate on which a pattern of the mask is to be exposed, relative to the slit illumination area. The pattern on the mask is exposed onto the photosensitive substrate by synchronously scanning the mask and the photosensitive substrate relative to the slit illumination area. Light shielding means for shielding an area on the mask which is not to be illuminated by the slit illumination area defined by the illumination optical system is also provided.

It is preferable to provide auxiliary scan means for scanning the light shielding means in synchronism with the scan of the mask by the relative scan means.

It is also preferable that the relative scan means is shared by the auxiliary scan means and the auxiliary scan means integrally scans the mask and the light shielding means.

The light shielding means may shield a predetermined fixed area on the mask.

In accordance with the present invention, the slit illumination area on the mask is defined by illumination area defining means (diaphragm member) arrange at a spaced position from the mask, for example, in a plane in the illumination optical system which is conjugate with the mask. Since the illumination area defining means is at the spaced position from the mask, the illumination area defining means may be precisely prefabricated or preadjusted so that a high uniformity of illumination on the photosensitive substrate after the scan is maintained.

When the illumination area defining means is arranged at the spaced position from the mask and the illumination area defining means is not to be driven during the first scanning exposure, and if a pattern of a desired circuit pattern area of a plurality of circuit pattern areas which are adjacent in the mask along the scan direction is to be exposed onto the photosensitive substrate, patterns of the other circuit pattern areas may also be exposed onto the photosensitive substrate. Thus, the other circuit pattern areas are shielded by the light shielding means arranged in the vicinity of the mask to prevent the exposure of the patterns of the other circuit pattern areas.

Where the auxiliary scan means for scanning the light shielding means in synchronism with the scan of the mask by the relative scan means is provided, it is not necessary to change the shape of the opening of the light shielding means during one exposure cycle and the control of the light shielding means is facilitated.

Where the relative scan means is shared by the auxiliary scan means and the relative scan means integrally scans the mask and the light shielding means, it is not necessary to additionally provide the scan means for the light shielding means and the construction is simplified.

Where the light shielding means shields the predetermined fixed area on the mask, it is not necessary to provide a mechanism for changing the shape of the opening in the light shielding means.

In accordance with the exposure method of the present invention, a slit illumination area on a mask on which a pattern to be transferred is formed is illuminated, and the mask and a photosensitive substrate are synchronously scanned relative to the slit illumination area to expose the pattern on the mask onto the photosensitive substrate. A measurement mask having an opening formed therein to pass a light of the slit illumination area therethrough is arranged and a width of an area corresponding to the slit illumination area on the photosensitive substrate along the scan direction is measured. A scan velocity of the mask and the photosensitive substrate and an exposure energy per unit time in the area on the photosensitive substrate corresponding to the slit illumination area are controlled in accordance with the measured width.

The exposure apparatus of the present invention comprises an illumination optical system for illuminating a slit illumination area on a mask on which a pattern to be transferred is formed, and relative scan means for synchronously scanning a photosensitive substrate to which a pattern of the mask held on a stage is to be exposed and the mask relative to slit illumination area. The mask and the photosensitive substrate are synchronously scanned relative to the slit illumination area to expose the pattern on the mask onto the photosensitive substrate. Measurement means is mounted on the stage for measuring the width of the slit illumination area on the photosensitive substrate along the scan direction, and exposure intensity control means for controlling the exposure energy to the photosensitive substrate in accordance with the measured width is provided.

It is preferable that the measurement means is shared by photoelectric detection means for measuring the uniformity in the illumination on the stage of the illumination light from the illumination optical system.

It is further preferable to provide correction means for correcting the width of the slit illumination area along the scan direction in accordance with the width along the scan direction of the slit illumination means measured by the measurement means.

In accordance with the exposure method of the present invention, the actual width along the scan direction of the area corresponding to the slit illumination area on the plane of the photosensitive substrate is measured before the pattern of the mask is exposed onto the photosensitive substrate. Accordingly, the scan velocity of the mask and the photosensitive substrate relative to the slit illumination area and the exposure energy per unit time to the photosensitive substrate are controlled in accordance with the measured width to precisely control the exposure intensity to the photosensitive substrate to a proper exposure intensity.

In accordance with the exposure apparatus of the present invention, the width along the scan direction of the area on the photosensitive substrate corresponding to the slit illumination area may be measured by the measurement means and the exposure intensity to the photosensitive substrate is precisely controlled to the proper exposure intensity in accordance with the measured width.

Where the measurement means is shared by the photoelectric detection means for measuring the uniformity in the illumination on the stage of the illumination light from the illumination optical system, it is not necessary to additionally provide the measurement means.

Where the correction means for correcting the width of the slit illumination area along the scan direction in accordance with the width along the scan direction of the slit illumination area on the photosensitive substrate measured by the measurement means is provided, the width may be precisely set to the preset width.

BRIEF DESCRIPTION OF THE DRAWINGS

Fig. I shows a configuration of one embodiment of a projection exposure apparatus of the present invention,

Fig. 2 shows a configuration of a drive mechanism for a reticle R and light shielding plates 8A and 8B of Fig. I,

Fig. 3A shows a plan view of a pattern on the reticle R of Fig. 1,

Fig. 3B shows a plan view of an arrangement of the light shielding plates 8A and 8B when a pattern of a circuit pattern area 20A is to be exposed,

Fig. 3C shows a plan view of an arrangement of the light shielding plates 8A and 8B when a pattern of a circuit pattern area 20B is to be exposed,

Fig. 4A shows a plan view when four light shielding plates are used,

Fig. 4B shows a plan view when the light shielding plates are fixed,

Figs. 5A and 5B show an example in which the shape precision of a slit illumination area along the scan direction affects to the uniformity of illumination after the scan,

Figs. 6A and 6B show another example in which the shape precision of a slit illumination area along the scan direction affects to the uniformity of illumination after the scan,

Fig. 7 shows a relation between a plurality of circuit pattern areas arranged on the reticle and the slit illumination area,

Fig. 8 shows a configuration of another embodiment of the projection exposure apparatus of the present invention,

Fig. 9 shows a plan view for illustrating the measurement of a width of a slit exposure area 126P along the scan direction,

Fig. 10A shows a waveform of a photoelectrically converted signal produced when the width of the slit exposure area is measured,

Fig. 10B shows a waveform of a design value of the photoelectrically converted signal produced when the width of the slit exposure area is measured, and

Figs. IIA to IID show plan views of various examples of conjugate images (slit exposure areas) of the slit illumination area on the photosensitive substrate.

DETAILED DESCRIPTION OF THE PREFERRED EMBODIMENTS

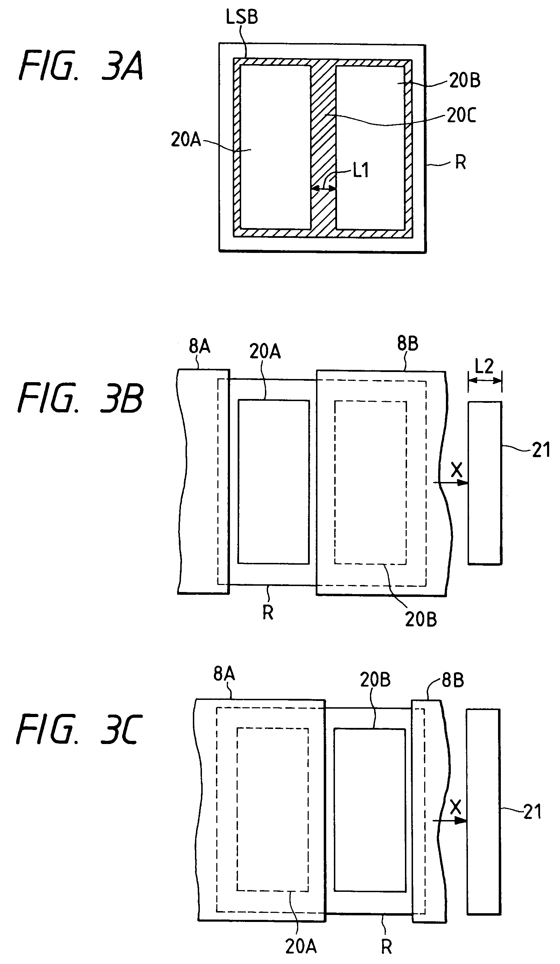

An embodiment of the exposure apparatus of the present invention is now explained with reference to Figs. 3A to 3C. In the present embodiment, the present invention is applied to a scanning projection exposure apparatus.

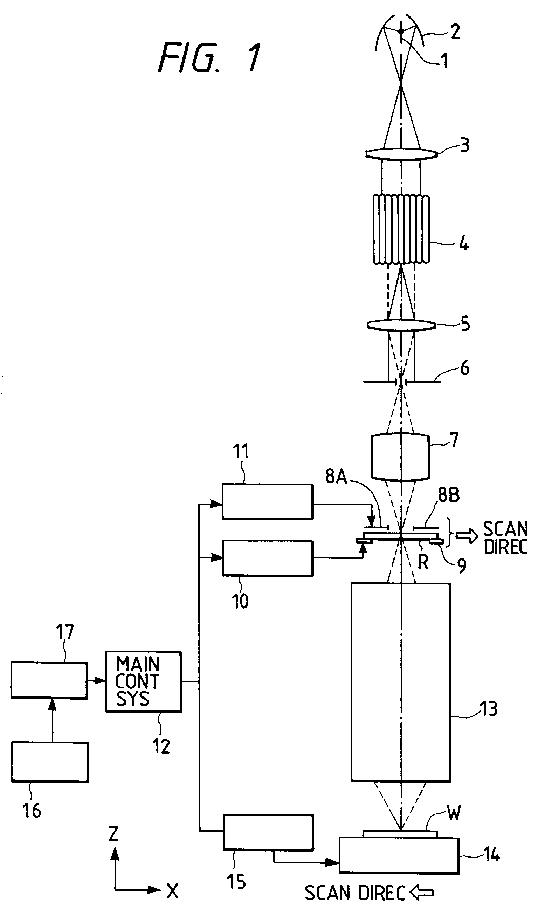

Fig. I shows a projection exposure apparatus of the present embodiment. In Fig. 1, a reticle R is illuminated by a rectangular slit illumination area with a uniform illumination through an illumination optical system including a light source 1 to a relay lens 7, and a circuit pattern of the reticle R illuminated by the slit illumination area is transferred onto a wafer W by a projection optical system 13.

An illumination light from the light source 1 such as a mercury lamp is focused by an elliptic mirror 2 and collimated by a collimator lens 3, and it is directed to a fly eye lens 4. Where the light source is a coherent light source such as an excimer laser light source, the illumination light emitted from the coherent light source passes through a beam shaping optical system such as a cylindrical lens or a beam expander instead of the elliptic mirror 2 and the collimator lens 3 and it is directed to the fly eye lens 4. A number of secondary light sources are formed on an exit plane of the fly eye lens 4 and the illumination lights from the exit plane are condensed by a condenser lens 5 and directed to a view field diaphragm 6.

A rectangular slit opening is formed in the view field diaphragm 6. The light beam transmitted through the view field diaphragm is converted to a light beam having a slit shaped sectional area and it is directed to the relay lens 7 which serves to render the view field diaphragm 6 and the circuit pattern formation plane of the reticle R conjugate. The illumination light is projected to the area on the reticle R which is conjugate with the slit opening of the view field diaphragm 6, that is, the slit illumination area on the reticle R. The relay lens system 7 is a double-end teleocentric optical system and the teleocentricity is maintained in the rectangular slit illumination area on the reticle R.

In the reticle R of the present embodiment, two light shielding plates 8A and 8B spaced along the scan direction for the slit illumination area are arranged on the reticle R closely to the reticle R, and the reticle R and the light shielding plates 8A and 8B are mounted on a reticle stage 9. A reticle blind is formed by the light shielding plates 8A and 8B, and an image of the circuit pattern on the reticle R between the light shielding plates 8A and 8B in the slit illumination area is projected and exposed onto a wafer W through a projection optical system 13. In a two-dimensional plane perpendicular to an optical axis of the projection optical system 13, X represents the scan direction of the reticle to the slit illumination area and Z represents a direction parallel to the optical axis of the projection optical system 13.

The reticle R and the light shielding plates 8A and 8B are integrally driven by a reticle stage drive unit 10 along the X axis which is in the scan direction, and the light shielding plates 8A and 8B are supported on the reticle stage 9 such that they are independently driven along the X axis by a light shielding plate drive unit 11. The operation of the reticle stage drive unit 10 and the light shielding plate drive unit 11 is controlled by a main control unit 12 which controls the overall operation of the apparatus. The wafer W is mounted on a wafer stage 14 which comprises an XY stage for positioning the wafer W in a plane normal to the optical axis of the projection optical system 13 and a Z stage for positioning the wafer W along the Z axis. The main control unit 12 controls the positioning of the wafer stage 14 and the scan operation through a wafer stage drive unit 15.

When the pattern on the reticle R is to be exposed to the wafer W through the projection optical system 13, the reticle R and the light shielding plates 8A and 8B are integrally scanned through the reticle stage along the X axis relative to the rectangular slit illumination area defined by the view field diaphragm 6. In synchronism with the scan, the wafer W is scanned through the wafer stage 14 along the -X axis relative to the image of the rectangular slit illumination area by the projection optical system. Namely, the -X axis is the scan direction of the wafer W. By synchronously scanning the reticle R and the wafer W, the circuit pattern of the reticle R is sequentially transferred onto the wafer W.

Recently, in order to improve a throughput by reducing a time required for the replacement of the reticle, it has been proposed to provide a plurality of circuit pattern areas on the reticle. In order to select a circuit pattern area to be transferred from the plurality of circuit patterns on the reticle R, the light shielding plates 8A and 8B are used. In the projection exposure apparatus of the present embodiment, an input unit 16 for inputting information on the circuit pattern area on the reticle R and a memory unit 17 for storing the input information of the input unit 16 are provided, and the main control unit 12 render the opening defined by the light shielding plates 8A and 8B to a predetermined shape through the light shielding plate drive unit 11 in accordance with the input information of the memory unit 17.

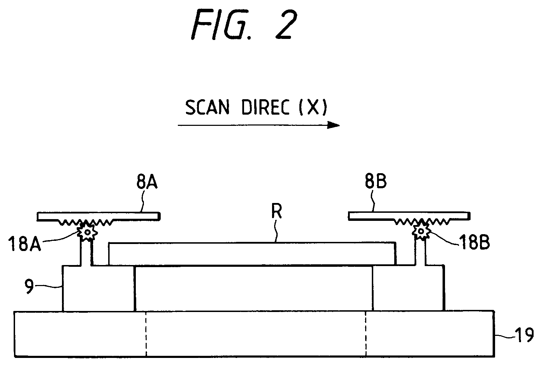

Referring now to Fig. 2, the drive mechanism for the light shielding plates 8A and 8B is explained.

Fig. 2 shows a detailed configuration of a periphery of the reticle R in Fig. I. In Fig. 2, the reticle stage 9 is slidably supported along the scan direction (X axis) on a reticle stage base 19, and the reticle R is held to an inner side of the reticle stage 9 by a vacuum chuck. A portion of the reticle stage 9 which corresponds to a circuit pattern formation area of the reticle R is an opening, and an area on the reticle stage base 19 which corresponds to a maximum slit illumination area is also an opening. The light shielding plates 8A and 8B are mounted to the opposite ends of the reticle stage along the scan direction through lead screw members 18A and 18B such as warms and gears. The lead screw members 18A and 18B are independently driven by the light shielding plate drive unit 11 of Fig. I to independently drive the light shielding members 8A and 8B along the scan direction.

In Fig. 2, the light shielding plate which is perpendicular to the plane of Fig. 2 and transverse to the scan direction (X axis) is not shown, but this light shielding plate in the non-scan direction may be arranged in the vicinity of the reticle R as are the light shielding plates 8A and 8B, or it may be arranged at a position which is substantially conjugate with the reticle R as is the view field diaphragm 6 of Fig. I.

In the embodiment of Fig. 2, the light shielding members 8A and 8B are integrally mounted through the lead screw members 18A and 18B on the reticle stage 9 which holds the reticle R and is movable along at least the X axis (scan direction). Accordingly, in the scan and exposure mode, the light shielding plates 8A and 8B are also driven along the scan direction (X axis) in synchronism with the scan of the reticle R by the reticle stage 9. As a result, in the present embodiment, it is not necessary to provide additional scan means for scanning (driving) the light shielding means 8A and 8B in synchronism with the scan of the reticle R. In other words, in the present embodiment, the reticle stage 9 and the drive unit 10 correspond to the auxiliary scan means for the light shielding means 8A and 8B.

Instead of providing the light shielding plates 8A and 8B on the reticle stage as they are in the present embodiment, the light shielding plates 8A and 8B may be arranged on the reticle stage base 19 of Fig. 2. In this case, however, even if the reticle R is moved along the scan direction (X axis) by the reticle stage 9, the light shielding plates 8A and 8B are not moved on the reticle stage base 19. In such a case, it is necessary to provide auxiliary scan means for driving the light shielding plates 8A and 8B in synchronism with the scan of the reticle R, as the auxiliary scan means, a movable member which holds the light shielding plates 8A and 8B on the reticle stage base 19 and is movable along at least the X axis, and a control unit for driving the movable member in synchronism with the scan of the reticle R may be provided. Specifically, the light shielding plates 8A and 8B are provided on the reticle stage base 19 through the lead screw members 18A and 18B and the control unit 11 drives the light shielding plates 8A and 8B in synchronism with the scan of the reticle R.

In the present embodiment, the light shielding plates 8A and 8B are arranged closely to the upper side (facing the light source I) of the reticle R as shown in Fig. I. Alternatively, the light shielding plates 8A and 8B may be arranged on the lower side (facing the projection optical system 13) of the reticle R. Specifically, the light shielding plates 8A and 8B are arranged on the reticle stage base 19 through the lead screw members 18A and 18B in Fig. 2, or the light shielding members 8A and 8B may be integrally arranged on the reticle stage 9 through a fixed member (or the lead screw members). In the former case, however, it is necessary to drive the light shielding plates 8A and 8B by the lead screw members 18A and 18B in synchronism with the scan of the reticle R.

Usually, the reticle R has one or more circuit patterns and a light shielding band of a predetermined width is formed to surround the circuit pattern (Fig. 3A). In other words, the circuit pattern is formed within the area of a predetermined shape (normally rectangular) surrounded by the light shielding band. Accordingly, when the areas other than the circuit pattern to be transferred are to be shielded from the light by the light shielding plates 8A and 8B as described above, the light shielding plates 8A and 8B are positioned by the lead screw members 18A and 18B such that the edges of the light shielding plates 8A and 8B are brought into the light shielding band (LSB in Fig. 3A) which surrounds the circuit pattern to be transferred. As a result, the positioning precision of the light shielding plates 8A and 8B by the lead screw members 18A and 18B may be low. As described above, when the light shielding plates 8A and 8B are arranged on the reticle stage base 19, the light shielding plates 8A and 8B are driven in synchronism with the scan of the reticle R by the lead screw members 18A and 18B such that the edges of the light shielding plates 8A and 8B do not go beyond the light shielding band. In the following description, in order to simplify the description, it is assumed that the edges of the light shielding plates 8A and 8B are positioned in the light shielding band when the light shielding plates 8A and 8B are driven and the description thereof is omitted.

Referring to Figs. I and 3A to 3C, the operation of the exposure by a slit scan exposure system is explained. As shown in Fig. 3A, two circuit pattern areas 20A and 20B are formed on the reticle R, a light shielding area 20C having a width LI along the scan direction is formed on a boundary of the circuit pattern areas 20A and 20B and a light shielding band LSB of a predetermined width is formed on an outer side of the circuit pattern areas 20A and 20B to surround them. As shown in Fig. 3B, a rectangular slit illumination area formed on the reticle R is a slit illumination area 21 having a width L2 along the scan line where the width L2 is larger than the width LI of the light shielding area 20C.

An operator first enters information on the circuit pattern areas 20A and 20B on the reticle R into the memory unit 17 through the input unit 16 of Fig. I. When the first circuit pattern area 20A is to be transferred onto the wafer W through the projection optical system 13, the main control unit 12 reads the information on the circuit pattern area 20A in the input information stored in the memory unit 17 and controls the position of the scan of the light shielding plates 8A and 8B through the light shielding plate control unit in accordance with the read information. As a result, the second circuit pattern 20B on the reticle R is shielded and the illumination light of the slit illumination area 21 is projected to only the first circuit pattern area 20A as shown in Fig. 3B.

In the exposure mode, the main control unit 12 of Fig. 1 drives the reticle stage 9 through the reticle stage drive unit 10 to position the slit illumination area 21 at the upper right side of the circuit pattern area 20A on the reticle R, and drives the reticle stage 9 to integrally move the reticle R and the light shielding plates 8A and 8B along the scan line (X axis) so that it passes under the illumination area 21. In synchronism therewith, the main control unit 12 drives the wafer stage 14 through the wafer stage drive unit 15 to drive the wafer W along the scan line (-X axis). In this case, since the illumination light is projected to only the first circuit pattern area 20A on the reticle R, only the pattern of the first circuit pattern area 20A is transferred onto the wafer W.

When the pattern of the second circuit pattern area 20B on the reticle R is to be transferred onto the wafer W, the main control unit 12 reads the information on the second circuit pattern area 20B in the input information stored in the memory unit 17, and controls the position of the scan of the light shielding plates 8A and 8B through the light shielding plate drive unit 11 in accordance with the read information. As a result, as shown in Fig. 3C, the first circuit pattern area 20A on the reticle R is shielded by the light shielding plate 8A and the illumination light of the slit illumination area 21 is projected only to the second circuit pattern area 20B.

In the exposure mode, the main control unit 12 of Fig. I drives the reticle stage 9 through the reticle stage drive unit 10 to position the slit illumination area 21 at the upper right side of the second circuit pattern area 20B on the reticle R, and drives the reticle stage 9 to integrally move the reticle R and the light shielding plates 8A and 8B along the X axis so that it passes under the illumination area 21. In synchronism therewith, the main control unit 12 drives the wafer stage 14 through the wafer stage drive unit 15 to move the wafer W in -X direction. In this case, since the illumination light is projected to only the second circuit pattern area 20B on the reticle R, only the pattern of the second circuit pattern area 20B is transferred onto the wafer W.

In accordance with the present embodiment, since the areas other than the circuit pattern areas to be exposed are shielded by the light shielding plates 8A and 8B which serve as the reticle blind, only the pattern of the desired circuit pattern area can be exposed onto the wafer W even if the plurality of circuit pattern areas are formed on the reticle at a narrow interval along the scan direction. Accordingly, a plurality of circuit pattern areas may be formed on the reticle at a narrow interval.

In the present embodiment, the light shielding plates 8A and 8B are integrally driven with the reticle R. Alternatively, separate drive means for driving the light shielding plates 8A and 8B along the scan direction in synchronism with the reticle R may be provided. In this case, however, a high drive speed of the light shielding plates 8A and 8B is required because the reticle stage 9 of Fig. I may be driven at a high speed of 100 mm/sec or higher in the scan and exposure mode. As shown in Fig. 2 of the present embodiment, when the reticle R and the light shielding plates 8A and 8B are mounted on the reticle stage 9 to integrally move the reticle R and the light shielding plates 8A and 8B, separate drive means for the light shielding plates 8A and 8B is not necessary and the synchronism of the movement of the reticle R and the light shielding plates 8A and 8B is superior.

In the present embodiment, two circuit pattern areas are formed on the reticle R. The projection exposure apparatus of the present embodiment may be applicable to an application where three or more circuit pattern areas are provided on the reticle R.

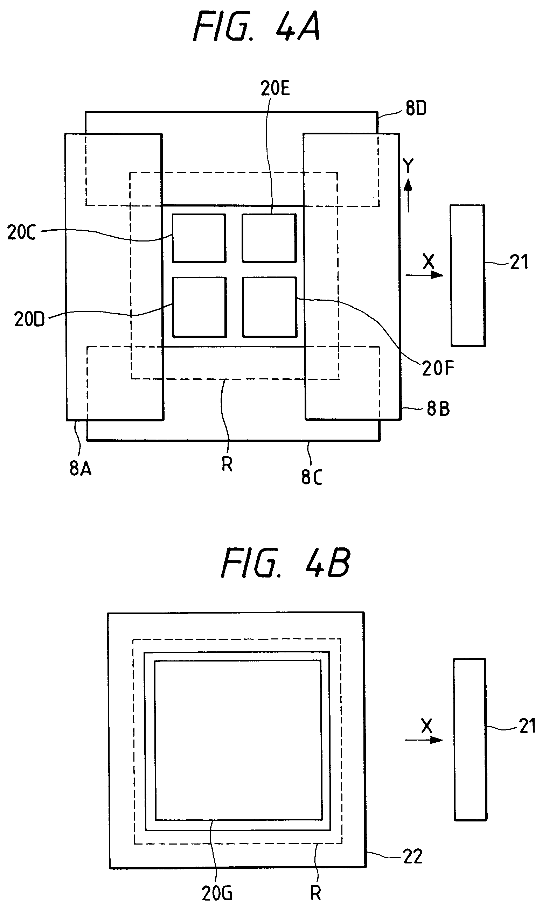

In this connection, as shown in Fig. 4A, where two light shielding plates 8C and 8D which are movable along the non-scan direction (Y axis) which is perpendicular to the scan direction are provided in addition to the light shielding plates 8A and 8B along the scan direction as shown in Fig. 4A, only the pattern of the desired circuit pattern area can be exposed to the wafer W even if a plurality of circuit pattern areas are formed on the reticle R along the non-scan direction. Namely, where four light shielding plates 20C to 20F are formed with the separation along the X axis and the Y axis on the reticle R, the illumination light may be projected to any one circuit pattern area of the four circuit pattern areas 20C to 20F by independently adjusting the positions of the four light shielding plates 8A to 8D. By integrally scanning the reticle R and the light shielding plates 8A to 8D relative to the slit illumination area 21 along the X axis, the pattern of the selected circuit pattern area on the reticle R may be exposed to the wafer W.

As shown in Fig. 4B, where only one circuit pattern area 20G is formed on the reticle R, the light shielding plate which serves as the reticle blind to shield a portion of the illumination area on the reticle R along the scan direction may be the light shielding plate 22 fixed on the reticle stage. In this case, the control unit for changing the range of light shield by the light shielding plate 22 is not necessary. Where such fixed light shielding plate 22 is provided, the sensitization of the wafer be the leakage of the illumination light from the periphery of the reticle R at the start or end of the slit scan exposure is prevented.

In the present embodiment, the light shielding plates 8A and 8B are moved as the reticle R is driven. In any case, the light shielding plates 8A and 8B may be moved such that the openings thereof always coincide with the circuit pattern area on the reticle R which is to be exposed. For example, where the reticle R and the wafer W are fixed and the exposure is made while the slit illumination area is scanned relative to the reticle R, it is not necessary to move the light shielding plates 8A and 8B during the exposure. Further, the shape of the slit illumination area, that is, the shape of the opening of the view field diaphragm 6 is not limited to the rectangle but it may be hexagonal as disclosed in Japanese Patent Publication No. 46-34057 and USP 4,924,257, or it may be of diamond shape as disclosed in Japanese Patent Publication No. 53-25790, or it may be arcuate as disclosed in USP 4,747,678.

The projection optical system 13 in the present embodiment may be a diffraction type, a reflection type or a reflection-diffraction type. The present invention is not limited to the projection exposure apparatus but it may be applicable to an exposure apparatus of a contact type or a proximity system. The present invention is not limited to the above embodiment but various modifications thereof may be made without departing from the spirit of the present invention.

In accordance with the present invention, since the light shielding means for shielding the area on the mask which is not to be illuminated is provided, the illumination area defining means for defining the slit illumination area on the mask may be arranged at the spaced position from the mask in the illumination optical system. Accordingly, the width of the illumination area defining means along the scan direction may be controlled at a high precision, and the uniformity of illumination on the photosensitive substrate after the scan and exposure can be maintained at a high level. Even when a plurality of pattern areas are formed on the mask along the scan direction at a narrow interval, only the pattern of the desired pattern area can be exposed to the photosensitive substrate.

Where the auxiliary scan means for scanning the light shielding means in synchronism with the scan of the mask by the relative scan means is provided, it is not necessary to control the status of the opening of the light shielding means during one scan cycle and the control of the status of the opening of the light shielding means is facilitated.

Where the relative scan means is shared by the auxiliary scan means and the relative scan means integrally scan the mask and the light shielding means, it is not necessary to additionally provide the drive means for scanning the light shielding means.

Further, where the light shielding means shields the predetermined fixed area on the mask, the mechanism for controlling the status of the opening of the light shielding means is not necessary and the construction is simplified.

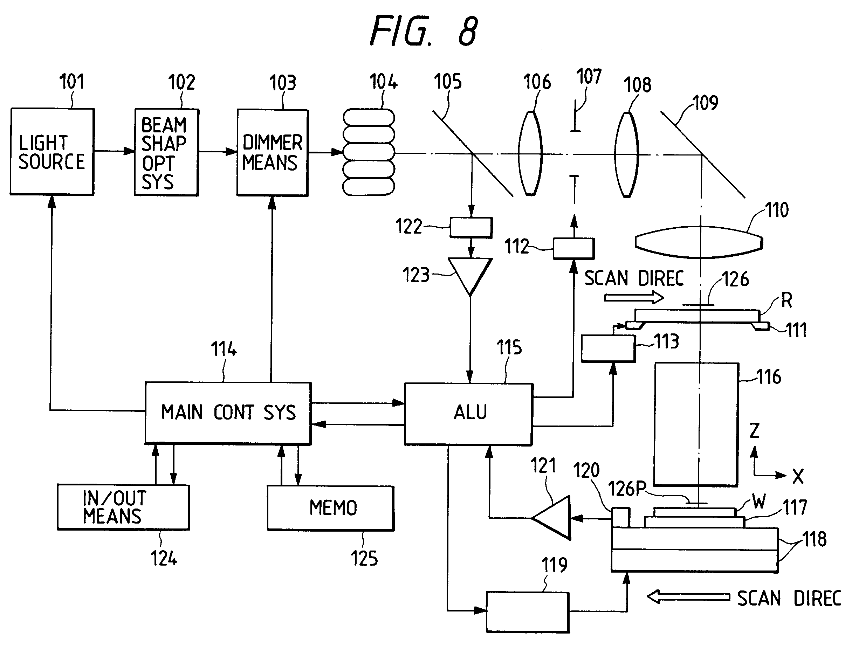

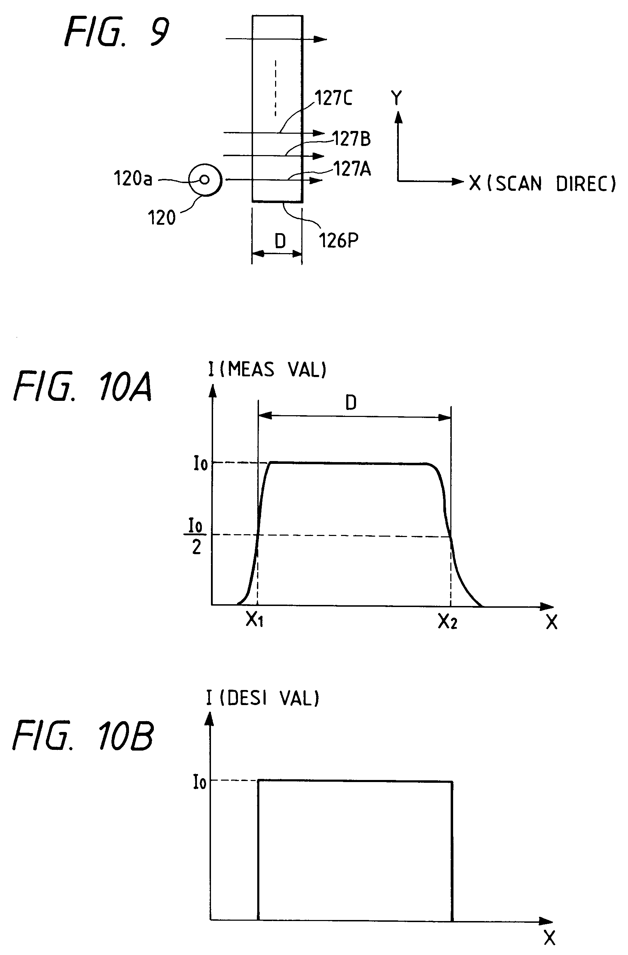

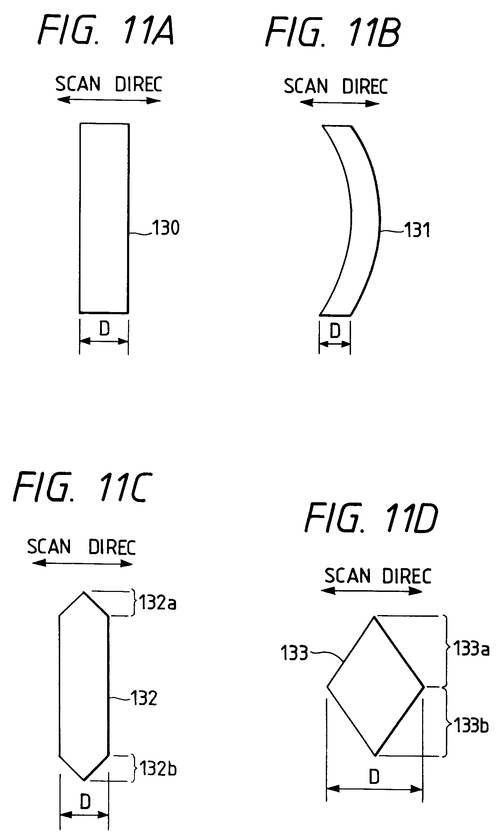

Referring now to Figs. 8 to 10A and 10B, another embodiment of the present invention is explained. In the present embodiment, the present invention is applied to a scanning projection exposure apparatus which uses a pulse oscillation type exposure light source such as an excimer laser light source.

Fig. 8 shows a projection exposure apparatus of the present embodiment. In Fig. 8, a sectional shape of a laser beam emitted from a light source 101 of a pulse oscillation type is shaped by a beam shaping optical system 102 including a cylindrical lens and a beam expander so that it is directed to a fly eye lens 104 with a high efficiency. The laser beam emitted from the beam shaping optical system 102 is directed to dimmer means 103 which includes a coarse transmission adjuster and a fine transmission adjuster. The laser beam emitted from the dimmer means 105 is directed to the fly eye lens 104.

The fly eye lens 104 illuminates a view field diaphragm 107 and a reticle R with a uniform illumination. The laser beam emitted from the fly eye lens 104 is directed to a beam splitter 105 having a small reflection coefficient and a small transmission, and the laser beam transmitted through the beam splitter 105 illuminates the view field diaphragm 107 through a first relay lens 106 with a uniform illumination. The shape of the opening of the view field diaphragm 107 in the present embodiment is rectangular.

The laser beam transmitted through the view field diaphragm 107 passes through a second relay lens 108, a deflection mirror 109 and a main condenser lens 110 and illuminates the reticle R on a reticle stage 111 with a uniform illumination. The view field diaphragm 107 and the pattern formation plane of the reticle R are conjugate and the laser beam is projected to a rectangular slit illumination area 126 on the reticle R which is conjugate with the opening of the view field diaphragm 107. The shape of the slit illumination area 126 may be adjusted by changing the shape of the opening of the view field diaphragm 107 as it is in USP 5,194,893.

An image of a pattern in the slit illumination area on the reticle R is exposed onto the wafer W through a projection optical system 116. Assuming that Z axis is parallel to an optical axis of the projection optical system 116 and X axis represents the scan direction of the reticle R relative to the slit illumination area 126 in a plane normal to the optical axis, the reticle stage 111 is scanned along the X axis by a reticle stage drive unit 113 which is controlled by an arithmetic and logic unit 115 operated by a main control unit 114 which controls the overall operation of the apparatus.

On the other hand, the wafer W is mounted on an XY stage 118 which can be scanned along at least X axis (lateral in Fig. 8) through a wafer holder 117. While not shown, a Z stage for positioning the wafer W along the Z axis is mounted between the XY stage 118 and the wafer holder 117. In the scan and exposure mode, the wafer W is scanned along the -X axis through the XY stage 118 in synchronism with the scan of the reticle R along the X axis but the XY stage 118 is driven by a wafer stage drive unit 119.

A photoelectric detector 120 is mounted on the XY stage 118. In the present embodiment, the shape of the slit exposure area 126P which is conjugate with the slit illumination area 126 on the reticle is measured by using the photoelectric detector 120. As disclosed in USP 4,465,368, the photoelectric detector 120 is also used to measure the uniformity of the illumination of the laser beam which serves as the exposure light on the XY stage 118. An integration of a pin hole formed at the same level as the surface of the wafer W and a photo-diode, a PIN photo-diode or a photo-multiplier arranged below the pin hole may be used as the photoelectric detector 120. In order to measure the shape of the slit exposure area 126P, a linear array sensor or a two-dimensional array sensor may be used as the photoelectric detector 120. The photoelectrically converted signal from the photoelectric detector 120 is sent to the arithmetic and logic unit 115 through an amplifier 121.

The laser beam reflected by the beam splitter 105 is sensed by an exposure intensity monitor 122 which includes a photoelectric conversion element, and a photoelectrically converted signal of the exposure intensity monitor 122 is supplied to the arithmetic and logic unit 115 through an amplifier 123. As will be explained later, the arithmetic and logic unit 115 determines the shape of the slit exposure area 126P by using the photoelectric detector 120 and adjusts the shape of the opening of the view field diaphragm 107 through the drive unit 112 based on the measurement or adjusts the scan velocity of the reticle R and the wafer W relative to the slit illumination area 126. The measurement of the shape of the slit exposure area 126P is supplied to the main control unit 114 which controls an output power of the light source 101 as required or controls the transmission in the dimmer means 103. The operator may enter the pattern information of the reticle R to the main control unit 114 through the input/output means 124, and the main control unit includes a memory 125 for storing various information.

An exposure operation in the present embodiment is now explained. Before the exposure, a reticle (for measuring the illumination shape) having an opening through which the light of the slit illumination area 126 is to be passed is defined as the reticle R, and the reticle R is positioned through the reticle stage 111 such that the opening of the reticle is positioned under one edge of the slit illumination area 126. Instead of using such reticle for measuring the illumination shape, a conventional reticle with an opening for the measurement may be used. The opening of the reticle need not be larger than the slit illumination area 126 and it is sufficient if it is larger than the dimension of the sense area of the photoelectric detector 120 on the XY stage 118 (the dimension of the pin hole when it is provided), converted to the equivalent reticle surface area.

If the uniformity of the illumination on the wafer W in a static state without scan is maintained, the reticle stage 111 may be positioned along the scan direction such that the opening on the reticle coincides with one edge of the slit illumination area 126. The reticle having such opening formed therein is to be inserted because the optical length may vary without such reticle and the conjugate relationship between the view field diaphragm 107 and the surface of the wafer W is shifted. Where the opening on the reticle is relatively large, the slit exposure area 126P in the projection image of the opening on the reticle is scanned along the X direction by the photoelectric detector 120 through the XY stage 118 while the reticle stage 111 is fixed.

Fig. 9 shows a scan method of the photoelectric detector 120 to the slit exposure area 126P. In Fig. 9, a photosensing element 120A of the photoelectric detector 120 is scanned to the slit exposure area 126P along a locus 127A in the X axis to measure the position of the edge of the exposure area 126P along the scan line. For example, the width W of the slit exposure area 126P is measured along loci 127A, 127C, .... defined at a predetermined interval along the Y axis normal to the X axis to measure the shape of the slit exposure area 126P even if it is arcuate.

Where the excimer laser light source is used as the light source 101 of the present embodiment, the excimer laser light source is of pulse oscillation type and it emits light by a light emission trigger supplied from the main control unit 114. A position information output from a length measurement device (for example, a laser interferometer), not shown, which monitors the position of the XY stage 118 in synchronism with the light emission trigger, and an output signal of the photoelectric detector 120 through the amplifier 121 are supplied to the arithmetic and logic unit 115. Where a variance of the pulsive light emission energy of the excimer light source is large, the output signal of the photoelectric detector 120 may be divided by the output signal of the exposure intensity monitor 122 to compensate for the variance of the energy.

The photoelectrically converted signal I produced from the photoelectric detector 120 when the slit exposure area 126P is scanned by the photoelectric detector 120 along the X axis is rectangular in design as shown in Fig. 3B. In actual, however, it is a waveform as shown in Fig. 3A due to a setting error of the view field diaphragm 107 and an aberration of the illumination optical system. Thus, a position $X_1$ along the X axis when the photoelectrically converted signal I is sliced at a 1/2 level of maximum value $I_0$ of the photoelectrically converted signal I is taken as one edge of the slit exposure area 126P.

Similar measurement is made while the photoelectric detector 120 is moved to the vicinity of the other edge of the slit exposure area 126P. Where the laser beam in the slit illumination area 126 is shielded by the light shielding pattern of the reticle, the opening on the reticle is moved immediately beneath the other edge of the slit illumination area 126. Then, the reticle is stopped and the photoelectric detector 120 is scanned to measure the position of the other edge of the slit exposure area 126P. A position $X_2$ of the other edge is determined based on the measurement. A width D of the slit exposure area 126P along the scan line is determined based on a difference between the position $X_1$ and the position $X_2$.

If the opening on the reticle is smaller than the edge area of the slit exposure area 126P shown in Fig. 3A, the reticle stage 111 is to be synchronously scanned as well in addition to the wafer stage 118 when the position $X_1$ and the position $X_2$ are measured.

If the opening of the view field diaphragm 107 is movable by the drive unit 112, it is necessary to check the uniformity of the width D along the non-scan direction (Y axis) because, if the width D is not uniform along the non-scan direction, the uniformity of the illumination on the wafer W after the exposure by the scan exposure system would be lost. Thus, it is necessary to measure the width D by the photoelectric detector 120 at two or more points, for example, at three points, a center and the opposite ends of the exposure area 126P as shown in Fig. 9. If the uniformity of the width of the opening of the view field diaphragm 107 along the scan direction is not sufficiently high, fine adjustment is made by the drive unit 112 to attain the parallelism of the view field diaphragm.

Where the photoelectric detector 120 is not of pin hole type but is a linear array sensor arranged along the Y axis, the measurement along the non-scan direction may also be done in one scan and measurement cycle but it is necessary to form a large opening in the reticle along the Y axis which is conjugate with the photosensor of the array sensor. Where the photoelectric detector 120 is a two-dimensional array sensor and the area thereof is larger than the slit exposure area 126P, the shapes of the slit exposure area 126P along the scan direction and the non-scan direction may be measured in one static state measurement but it is necessary to form a larger opening in the reticle.

If the view field diaphragm 107 is of fixed type which is well pre-adjusted, the width D of the slit exposure area 126P may be measured occasionally to monitor the change by aging and the apparatus constant in the memory unit 125 may be modified based on the measurement. Where the parallelism of the opposite edges of the slit exposure area 126P is assured, it is sufficient to measure the width D at one point along the non-scan direction.

In Fig. 8, after the width D of the slit exposure area 126P along the scan direction measured in the manner described above has been stored in the memory unit 125, the reticle R for the exposure is mounted on the reticle stage 111 and the wafer W for the exposure is mounted on the wafer holder 117, and the actual exposure operation is started. The operator first enters a proper exposure intensity for the wafer W to the main control unit 114 from the input/output means 124, and the proper exposure intensity is sent to the arithmetic and logic unit 115. Then, the illumination of the exposure plane of the wafer W is measured. The illumination of the exposure plane of the wafer W may be measured by an exposure intensity monitor 122 which is well correlated to a pulse energy P (mJ/cm$^2 \cdot$ pulse) on the exposure plane of the wafer W, or by using an output signal of the photoelectric detector 120 on the XY stage 118.

When the measurement of the pulse energy P of the pulse laser beam from the light source 101 is completed, parameters for controlling the exposure intensity are determined in the following manner. In the following description, it is assumed for the sake of simplicity that the variance of the pulse energy P is sufficiently low and the pulse energy P may be considered as a constant value. Assuming that f (Hz) represents the oscillation frequency of the light source 101, the illumination I (mW/cm$^2$) on the exposure plane of the wafer is given by:

$$I = P \cdot f \qquad (2)$$

The number N of pulses required for the exposure is given by:

$$N = f \cdot t \qquad (3)$$

where t (sec) represents the exposure time. From the formulas (2) and (3),

$$N = S/P = Df/v \qquad (4)$$

where S (mJ/cm$^2$) represents the proper exposure intensity on the wafer, and v (mm/sec) represents the scan velocity of the reticle and the wafer converted to that on the exposure plane of the wafer.

It is seen from the formula (4) that it is necessary to control such that S/P and Df/v are integers. The more the values of S/P and Df/v deviate from integers, the more are the uniformity of the illumination on the wafer after the exposure by the scan exposure and the precision of control of the exposure intensity deteriorated. In order to render S/P to an integer, the pulse energy P is finely controlled. This is done by finely adjusting the transmission of the dimmer means 103 of Fig. 8.

On the other hand, in order to render Df/v of the formula (4) to an integer, it is necessary to finely adjust the width W of the slit exposure area 126P, the oscillation frequency f or the scan velocity v. Where the width D is to be adjusted, the view field diaphragm 107 is finely adjusted by the drive unit 112. If the precision of the fine adjustment is not sufficiently high, it is necessary to remeasure the width D of the slit exposure area 126P. Where the oscillation frequency f or the scan velocity v is to be adjusted, it is adjusted such that it is within the variable range.

In the above description, it has been assumed that the variance of the pulse energy P of the excimer laser light source is sufficiently small. In actual, however, the excimer laser light source has a variance of approximately 5% (three times of a standard deviation $\sigma$). Assuming that PB represents a mean value of the pulse energy and $\Delta P$ represents the variance of the pulse energy P, the variance of the pulse energy P is represented by $\Delta P/PB$. If a reproduction precision A of the exposure intensity is to be within 1% ($3\sigma$), it is necessary that the number N of pulse of the formula (4) should meet the following relation:

$$N \geq \{(\Delta P/PB)/A\}^2 = 25 \qquad (5)$$

If the proper exposure intensity S is small, it is necessary to reduce the pulse energy P in the formula (4) and the transmission is adjusted by the coarse adjustment unit in the dimmer means 103 in accordance with a command from the main control unit 114. After the parameters relating to the exposure given by the formula (4) have been determined, the reticle R and the wafer W are synchronously scanned at the velocity v converted to that of the wafer plane and the light source 101 is oscillated at the frequency f so that the exposure intensity of the wafer W is controlled to the desired one with the desired uniformity of illumination and the desired precision of control of the exposure intensity.

In the present embodiment, it is assumed that the pulsive light source such as an excimer laser light source is used as the light source. Where a g-ray or an i-ray is taken from a continuous light source such as a mercury lamp for use as the exposure light, the beam shaping optical system 102 of Fig. 8 comprises a collimator lens and an interference filter. The condition for setting the parameters relating to the exposure of the formula (4) is represented by the formula (1), and the illumination I on the exposure plane of the wafer, the width D of the slit exposure area and the scan velocity v may be adjusted in accordance with the proper exposure intensity S.

Where the exposure light source is the continuous light source, the dimmer means 103 of Fig. 8 is usually not essential and the adjustment may be made by the scan velocity v and the width D such that the scan velocity v is reduced for a large exposure intensity and the scan velocity v is increased for a small exposure intensity. When the scan velocity v reaches a maximum velocity permitted to the apparatus, it is necessary to reduce the width D of the slit exposure area. While it is assumed that the view field diaphragm 107 is arranged in the plane which is conjugate with the pattern plane of the reticle R in the illumination optical system, it may be arranged closely to the reticle R.

The projection optical system in Fig. 8 may be of diffraction type, reflection type or reflection-diffraction type. The present invention is not limited to the projection exposure apparatus but it is equally applicable to a contact type or proximity type exposure apparatus. Thus, the present invention is not limited to the illustrated embodiments but various modifications thereof may be made without departing from the spirit of the invention.

In accordance with the present invention, since the width of the area corresponding to the slit illumination area along the scan direction may be measured on the plane of the photosensitive substrate, the exposure with the proper exposure intensity can be attained to the photosensitive substrate by using the measured width. The uniformity of illumination on the photosensitive substrate is also improved.

In the exposure apparatus of the present invention, where the measurement means is shared by the photoelectric detection means for measuring the uniformity of illumination on the stage of the illumination light from the illumination optical system, the configuration of the apparatus may be simplified.

Where the correction means for correcting the width of the slit illumination area along the scan direction based on the width of the slit illumination area on the photosensitive substrate along the scan direction measured by the measurement means, the width of the slit illumination area may be precisely set to the desired width.

## Claims

1.  An apparatus for exposing a pattern formed on a mask to a photosensitive substrate comprising:

    an illumination optical system for illuminating said mask;

    said illumination optical system including a stop member arranged in a plane conjugate with the pattern of said mask or in the vicinity thereof for restricting an illumination area on said mask to a local area;

    scanning system for synchronously scanning said mask and said photosensitive substrate relative to said illumination area along a predetermined direction to expose the pattern of said mask to said photosensitive substrate; and

a light shielding member arranged in the vicinity of said mask for shielding a light directed to said photosensitive substrate through the outside of the pattern area on said mask during the scan of said mask and said photosensitive substrate.

2. An apparatus according to Claim 1, further comprising:

a movable member for relatively moving said mask and said light shielding member in accordance with a size of the pattern area on said mask.

3. An apparatus according to Claim 1, wherein said light shielding member includes two light shielding plates arranged to hold said illumination area therebetween along said predetermined direction; and

said apparatus further comprising a drive member for independently driving said two light shielding members along said predetermined direction.

4. An apparatus according to Claim 1, wherein said scanning system includes a mask stage for holding said mask and driving said mask along said predetermined direction; and

said apparatus further comprising a member for integrally holding said light shielding member on said mask stage.

5. An apparatus according to Claim 4, wherein said hold member includes a drive member for driving said light shielding member relative to said mask.

6. An apparatus according to Claim 1, further comprising:

a drive member for driving said light shielding member along said predetermined member in synchronism with the scan of said mask by said scanning system.

7. An apparatus for exposing a pattern formed on a mask to a photosensitive substrate comprising:

an illumination system for irradiating an illumination light to a local area on said mask;

scanning system for synchronously scanning said mask and said photosensitive substrate relative to said local illumination area along a predetermined direction to expose the pattern on said mask to said photosensitive substrate; and

a light shielding member arranged in the vicinity of said mask for shielding an area on said mask which is to be protected from the illumination by the illumination light during the scan of said mask and said photosensitive substrate.

8. A method for exposing a pattern formed on a mask to a photosensitive substrate by projecting an illumination light emitted from a light source to the mask synchronously scanning said mask and said photosensitive substrate along a predetermined direction comprising the steps of:

synchronously scanning said mask which substantially transmits the illumination light therethrough and a photoelectric detector which senses the light transmitted through said mask along said predetermined direction;

measuring a width of an illumination area, along said predetermined direction, of the illumination light directed to said photosensitive substrate in accordance with a photoelectric signal produced from said photoelectric detector during the scan; and

scanning and exposing said mask and said photosensitive substrate in accordance with the measured width.

9. A method according to Claim 8, further comprising the steps of:

determining a scan velocity of said mask and said photosensitive substrate and an exposure intensity to be applied to said photosensitive substrate during the scan and exposure in accordance with the measured width; and

scanning and exposing said mask and said photosensitive substrate in accordance with the determined scan velocity and exposure intensity.

10. A method according to Claim 8, further comprising the steps of:

adjusting a width of the illumination area on said mask along said predetermined direction in accordance with the measured width; and

scanning and exposing said mask and said photosensitive substrate with the adjusted width.

11. An apparatus for exposing a pattern formed on a mask to a photosensitive substrate by synchronously scanning said mask and said photosensitive substrate along a predetermined direction comprising:

an illumination optical system for irradiating an illumination light to a local area on said mask;

a mask stage for holding said mask and driving said mask along said predetermined direction;

a substrate stage for holding said photosensitive substrate and driving said photosensitive substrate along said predetermined direction;

measuring device for measuring a width, along said predetermined direction, of an illumination light directed to said photosensitive substrate;

said measuring device including a photoelectric detector arranged on said substrate stage; and

controller for controlling an exposure intensity to be applied to said photosensitive substrate in accordance with the measured width.

12. An apparatus according to Claim 11, further comprising:

adjustment member for adjusting the width of the illumination area on said mask along said predetermined direction in accordance with the measured width.

13. An apparatus according to Claim 12, wherein said adjustment member includes a variable diaphragm arranged in a plane conjugate with the pattern of said mask in said illumination optical system or in the vicinity thereof.

## FIG. 1

# FIG. 2

SCAN DIREC (X) →

FIG. 3A

LSB

20A

20B

20C

R

L1

FIG. 3B

8A

20A

8B

L2

21

R

20B

X

FIG. 3C

8A

20B

8B

21

20A

R

X

# FIG. 4A

# FIG. 4B

# FIG. 5A    FIG. 5B

SCAN DIREC

30

# FIG. 6A    FIG. 6B

SCAN DIREC

31

# FIG. 7

SCAN DIREC

32B

32A

R

L1

L2

33

# FIG. 8

EP 0 614 124 A2

FIG. 9

127C

127B

127A

120a

120

D

126P

Y

X (SCAN DIREC)

FIG. 10A

I (MEAS VAL)

D

$I_0$

$\dfrac{I_0}{2}$

$X_1$

$X_2$

X

FIG. 10B

I (DESI VAL)

$I_0$

X

## FIG. 11A

SCAN DIREC

~130

D

## FIG. 11B

SCAN DIREC

~131

D

## FIG. 11C

SCAN DIREC

}132a

~132

}132b

D

## FIG. 11D

SCAN DIREC

133

}133a

}133b

D